# EUROPEAN PATENT APPLICATION

(11) **EP 2 860 540 A1**
(43) Date of publication of application: **15.04.2015**
(21) Application number: 13188437.1
(22) Date of filing: 14.10.2013
(51) Int. Cl.: G01R 33/032

(54) **Magnetic sensor arrangement**

(71) Applicant: Siemens Aktiengesellschaft, 80333 München (DE)
(72) Inventor: Frisvoll, Asbjoern, 7043 Trondheim (NO)

(57) **Abstract**

The present invention relates to a magnetic sensor arrangement (1) and a method (100) for detecting a change in a magnetic field.

To obtain a reliable sensing of a change in a magnetic field a magnetic sensor arrangement (1) comprises a magnetostrictive element (2) and an optical cavity/resonator (3) with said magnetostrictive element (2) being in a mechanical linkage (44) with said optical cavity/resonator (3).

The method (100) for detecting the change in a magnetic field comprising the steps of (a) sensing a change in a magnetic field on basis of a magnetostrictive effect (2) with transducing the change in the magnetic field in a shapes or dimensions change (38) by said magnetostrictive effect (2), (110), (b) transferring the shapes or dimensions change (38) in a change of a geometrical disposal (39) of an optical cavity/resonator (3) while illuminating (40) the optical cavity/resonator (3) by light (120) and (c) detecting a change of a physical property of the light (30), (41) illuminating (40) the optical cavity/resonator (3), (130) caused by the change of the geometrical disposal (39) of the optical cavity/resonator (3) with the change of the physical property (41) of the light (30) representing the change in the magnetic field.

## Description

### Field of invention

The present invention relates to a magnetic sensor arrangement and a method for detecting a change in a magnetic field.

### Art Background

Magnetic sensors are known as sensors detecting magnetic fields and/or changes in (external) magnetic fields (both in following just referred to as "change/-s in (external) magnetic field(-s)").

Magnetic sensors can be used in a wide range of industrial applications, as for example for speed, rotational speed, linear position, linear angle and position measurement in automotive, industrial and consumer applications with said detected changes in the (external) magnetic fields representing respective measurement variables.

There are many ways to sense magnetic fields. Most of them based on an intimate connection between magnetic and electrical phenomena exploiting a broad range of physics and chemistry disciplines implemented in respective sensing arrangements, i.e. in said magnetic sensors.

Most popular magnetic sensors, for example described in "A Review of Magnetic Sensors", James E. Lenz, Proceedings of the IEEE, Vol. 78, No. 6, June 1990, pp. 973 ff., are search coil sensors, SQUID sensors or Hall effect sensors as well as fiber optical sensors.

Said fiber optical sensor employs two optical, i.e. glass, fibers that are arranged to form a Mach-Zender interferometer.

Light from a laser passes through a beam splitter into the two fibers ("sensing arm", "reference arm"), travels along a length of the fibers, is recombined in a beam combiner, and arrives at a photodetector at the end of each fiber. One of the fibers, i.e. the "sensing arm", is either wrapped around or coated with a magnetostrictive material, a material whose dimensions depend on a direction and extent of its magnetization ("magnetostrictive effect").

When the magnetostrictive material is magnetized by an external magnetic field - and changes its dimension based on its "magnetostrictive effect", the length of the fiber ("sensing arm") changes respectively.

If the length of the fiber changes by a fraction of a wavelength, the light travelling through the fiber arrives at the beam combiner slightly out of phase with the light arriving from the reference fiber ("reference arm").

An interference of the two light waves causes the light level at the photodetectors to change by an amount dependent on the phase difference.

Said "magnetostrictive effect" ("magnetostriction") of said magnetostrictive material is well known, for example from http://en.wikipedia.org/wiki/Magnetostriction (20.09.2013).

Magnetostriction (cf. electrostriction) is a property of ferromagnetic materials that causes them to change their shape or dimensions during the process of magnetization. The variation of materials' magnetization due to the applied magnetic field changes the magnetostrictive strain until reaching its saturation value.

Another fiber optical sensor, labelled as a fiber-optic magnetostrictive transducer system, using optical fibers in combination with said magnetostrictive effect (on it) is known from US 5,305,075. The fiber-optic magnetostrictive transducer system consists of a sensing element having three dual-strip fiber optic magnetostrictive transducers bonded into a single fiber Mach-Zehnder interferometer operating single mode mounted in a symmetrical orthogonal geometry.

An optical cavity/resonator is known from "http://en.wikipedia.org/wiki/Optical_cavity" (20.09.2013). Such an optical cavity/optical resonator is an arrangement of opposing mirrors that forms a standing wave cavity resonator for light waves.

Light confined in the cavity - build by the opposing mirrors - of the optical cavity/resonator reflect multiple times producing standing waves for certain resonance frequencies.

Different resonator types are distinguished by a focal lengths of the two mirrors and a distance between them.

A common type of an optical cavity/resonator consists of two facing plane (flat) mirrors. The simplest of this is a plane-parallel or Fabry-Pérot cavity/resonator ("plane-parallel cavity/resonator"), consisting of two opposing flat mirrors - therefore building a Fabry-Pérot cavity.

While simple, this Fabry-Pérot cavity/resonator is rarely used in large-scale lasers due to the difficulty of alignment; the mirrors must be aligned parallelly within a few seconds of arc, or "walkoff" of the intracavity beam will result in it spilling out of the sides of the cavity.

The Fabry-Pérot cavity/resonator is also known as a basis of a Fabry-Pérot interferometer, for example known from "http://en.wikipedia.org/wiki/Fabry-Perot interferometer" (20.09.2013).

Interferometers generally, as especially in specific configurations as said Fabry-Pérot interferometer as well as a Mach-Zehnder interferometer or a Michelson interferometer, for example described in "http://en.wikipedia.org/wiki/Interferometer" (20.09.2013), make use of a principle of superposition to combine waves in a way that will cause a result of their combination to have some meaningful property that is diagnostic of an original state of the waves.

Magnetic sensors often show the disadvantage to be unimmune and sensible to noise from non-magnetic low frequency noise sources like temperature or vibration leading to unreliability in sensing magnetic fields.

It is an objective of the present invention to improve a magnetic sensing, i.e. a detection of a magnetic field and/or a change in a magnetic field, as well as to provide a reliable detection of such a magnetic field and/or such a change in a magnetic field.

This objective may be solved by a magnetic sensor arrangement and a method for detecting a change in a magnetic field according to the subject-matter of the respective independent claim.

### Summary of the Invention

According to the present invention, a magnetic sensor arrangement comprises a magnetostrictive element and an optical cavity/resonator with said magnetostrictive element being in a mechanical linkage with said optical cavity/resonator.

Said magnetostrictive element and said optical cavity/resonator being in said "mechanical linkage" can mean a mechanical operatively interaction between said magnetostrictive element and said optical cavity/resonator.

"Mechanical" could be understood as a concern of a behavior of physical bodies, when subjected to forces, loads, strains and/or displacements and the subsequent effects of the bodies on their environment.

Therefore, mechanical linked bodies, as said magnetostrictive element linked with said optical cavity/resonator, will be able to transfer - directly as well as indirectly - forces, loads, strains and/or displacements to each other.

Said mechanical operative interaction - between said optical cavity/resonator and said magnetostrictive element - of said mechanical linkage could therefore be direct, as a direct physical contact between said optical cavity/resonator and said magnetostrictive element, as well indirect - as a physical or functional "transmitter" "operating between" said optical cavity/resonator and said magnetostrictive element.

Also according to the present invention, a method for detecting the change in a magnetic field comprises the steps of (a) sensing a change in a magnetic field on basis of a magnetostrictive effect with transducing the change in the magnetic field in a shapes or dimensions change by said magnetostrictive effect, (b) transferring the shapes or dimensions change in a change of a geometrical disposal of an optical cavity/resonator while illuminating the optical cavity/resonator by light and (c) detecting a change of a physical property of the light illuminating the optical cavity/resonator caused by the change of the geometrical disposal of the optical cavity/resonator with the change of the physical property of the light representing the change in the magnetic field.

"Change in a magnetic field" could also be understood as a very occurrence or a very existence of "a magnetic field" (itself).

In other words, the invention is based on/uses the finding that a deformation, i.e. a shapes or dimensions change, of a magnetostrictive element - induced by a change in a(-n) (external) magnetic field (to be sensed) - can be passed to/induced on an optical cavity/resonator, with/because of said magnetostrictive element and said optical cavity/resonator being mechanically linked, leading to a change in a geometrical disposal of said optical cavity/resonator.

Said change of said geometrical disposal of the optical cavity/resonator can be a change in a geometrical disposal of opposing mirrors building a cavity of said optical cavity/resonator.

Simplified, the geometrical disposal of opposing mirrors of an optical cavity/resonator can be changed/influenced by the magnetic field/magnetostrictive element - with said magnetostrictive element being mechanically linked to said optical cavity/resonator.

As long as said changed geometrical disposal of said optical cavity/resonator would lead - while illuminating the optical cavity with light - to a change in a light propagation in the optical cavity/resonator, i.e. a change of a physical property of the light, for example an beams optical length or beams phase shift, - said "change" in light could be detected, for example by an interferometer, representing the change in the magnetic field to be sensed.

Therefore, the invention can provide a magnetic sensor capable of sensing low frequency and direct current (DC) magnetic fields, especially with low amplitudes.

The magnetic sensor can be construed very easily, very small (overall size) and/or at low cost as well as providing a reliable sensing of a magnetic field since being immune to noise from non-magnetic low frequency noise source, like temperatures or vibration.

The invention can also minimize demagnetization effects of magnetic sensors using magnetostrictive elements as long as small sensing elements, i.e. magnetostrictive elements can be used by the invention. A limitation - being inherent in known magnetic sensors using magnetostrictive elements - is that the larger the sensing element, i.e. the magnetostrictive element, is, the higher the demagnetization effect of the sensing element is (decrease in applied magnetic field by going deeper into the magnetostrictive material). This in effect means that you can not increase the sensing element and expect a better signal, rather you get a better signal to sensing element factor, the smaller the sensing element is.

The invention can also minimize a loading of a magnetic sensor as long as the magnetostrictive element transfers its strain (shapes or dimensions change) to said optical cavity/resonator which can be a thin and flexible structure. Said known fiber optical sensors have used optical fibers glued to thin magnetostrictive ribbons. The fibers are much thicker than the magnetostrictive ribbons and the fiber loading becomes limiting for the magnitude of the magnetic fields to be sensed by the magnetic sensor.

According to a preferred embodiment the magnetostrictive element is a magnetostrictive layer or a magnetostrictive ribbon of a material having magnetostrictive properties, for example an iron-boron alloy or MetGlas.

Said magnetostrictive layer or said magnetostrictive ribbon can have a thickness of about less than 20 µm, further more especially of about 0,1 µm to 10 µm.

Furthermore, said magnetostrictive layer or said magnetostrictive ribbon can be attached, for example using a sputtering or a gluing technique, to a tip ("end") of an optical fiber - with said optical cavity/resonator being provided by said optical fiber.

Said optical fiber can have a fiber core encased with a fiber cladding with said optical fiber having a cross section dimension of about 100 µm to 150 µm, especially of about 110 µm to 130 µm, and/or a length less of about 150 µm, especially of about 75 µm to 90 µm.

Said fiber core can have a cross section dimension of about 0,2 µm to 50 µm, especially of about 4 µm to 8 µm.

According to a preferred embodiment said optical cavity/resonator - comprising a cavity to be illuminated by light - is built by a Fabry-Perot cavity/resonator - comprising a Fabry-Perot cavity respectively.

Said optical cavity/resonator, i.e. said Fabry-Perot cavity/resonator, can be built using an/said optical fiber, with said cavity, i.e. said Fabry-Perot cavity, being provided by said optical fiber.

According to a preferred embodiment said optical cavity/resonator, especially said Fabry-Perot cavity/resonator, is being built by a cantilever arrangement.

Said cantilever arrangement can comprise a cantilever arm and a cantilever base with said cantilever arm being arranged in a preselectable distance to said cantilever base.

Said cantilever arm and said cantilever base - being arranged in said preselectable distance - can build said cavity, i.e. said Fabry-Perot cavity, of said optical cavity/resonator, i.e. said Fabry-Perot cavity/resonator.

According to a preferred embodiment said preselectable distance of said cantilever arm and said cantilever base ("length of the cavity") will be about 5 µm to 25 µm, especially about 5 µm to 10 µm. Said cantilever arm can have a thickness of about 5 µm to 25 µm, especially about 5 µm to 10 µm.

A dimension of the cavity (of the cantilever arrangement) ("width/broadness of the cavity") normal to the "length of the cavity" can be about 80 µm to 140 µm, especially of about 90 µm to 120 µm.

The cantilever arrangement can be built using an/said optical fiber. Here said cantilever arrangement can be arranged at a tip region of an/said optical fiber with the cantilever arm being an unattached end of the optical fiber.

Said magnetostrictive element can be attached to a surface of said cantilever arm of said cantilever arrangement, especially said surface of said cantilever arm ("tip/end surface" of said fiber) being opposite to a further surface of the cantilever arm with said further surface limiting said cavity of said optical cavity/resonator.

As long as said cantilever arrangement can be arranged at said tip region of an/said optical fiber with the cantilever arm being said unattached end of the optical fiber said cantilever arrangement can be a thin and flexible structure minimizing a fiber loading of the magnetic sensor arrangement, i.e. said fiber, while transferring said magnetostrictive elements strain (shapes and dimensions change) to said cantilever arrangement.

According to a preferred embodiment the mechanical linkage of said magnetostrictive element with said optical cavity/resonator is built by using a sputtering or gluing technique.

According to a preferred embodiment a first inner side of a/said cavity of said optical cavity/resonator is partially reflective ("in fiber reflector"), especially using a coating of a partially reflective material, whereas a second inner side of said cavity is fully reflective, especially using said magnetostrictive element.

For an enhanced/optimal performance of the magnetostrictive material of the magnetostrictive element, it could be advantageous to anneal the material with/without an applied magnetic field, especially in temperatures from 100 to 500 deg C in 0.5 to 5 hours. This treatment/annealing has an effect of increasing the magnetostriction of the magnetostrictive material and 'relaxing' the magnetostrictive material.

This treatment/annealing can happen after the magnetostrictive element is linked with the optical cavity/resonator, i.e. the magnetostrictive layer is deposited/attached to the "fiber cantilever", or before linking with the optical cavity/resonator, i.e. attaching/gluing to the "fiber cantilever".

According to a preferred embodiment the magnetic sensor arrangement further comprises a coil arrangement for producing a region of a nearly uniform magnetic field ("modulation field").

Said coil arrangement, for example a Helmholtz coil, can comprise - a pair of - circular magnetic coils that are placed symmetrically one on each side of a sensing area along a common axis with said optical cavity/resonator being placed in said sensing area.

A regularly wound coil of sufficient length may also be used

As long as said optical cavity/resonator will be placed in said sensing area, i.e. said region of said nearly uniform magnetic field ("modulation field"), a signal modulation (with said signal representing said (external) magnetic field) can be provided there through "lifting" said signal (away from DC) to a frequency where said signal, i.e. said signal representing said magnetic field to be sensed, does not carry interference from other signals like temperature fluctuations, vibrations etc.. Unimmunity to noise from non-magnetic low frequency noise sources like temperature or vibration can be enhanced.

In other words, as long as the magnetostrictive material strain is non-linear with applied magnetic fields, and by using said modulation by a controlled low strength externally applied magnetic field ("modulation field") said signal is lifted away (from DC) to a higher frequency where said signal does not carry interference from said other signals.

According to a preferred embodiment the magnetic sensor arrangement also comprises a laser source for producing an optical laser light. Here, said laser light can be of a single wavelength.

Furthermore, the magnetic sensor arrangement can also comprise an optical coupler (beam splitter/combiner, (de-)multiplexer) for dividing said optical laser light into a first beam ("reference beam") and a second optical beam ("sensing beam") (beam splitter) and/or for combining the first and the second optical beam into a composite optical beam (beam combiner).

A (photo-)detector (or (photo-)detectors) can be used for converting said composite optical beam into an electrical signal - or for converting said reference beam and said sensing beam into respective electrical signals.

A control unit can process the electrical signal/-s for detecting a phase difference/shift of/between said reference beam and said sensing beam - with said phase difference/shift - especially being a function of a path difference between two beams, i.e. the reference beam and the sensing beam - representing said magnetic field, i.e. said change in said magnetic field, to be sensed.

In other words, according to a preferred embodiment said physical property of said light is a optical length and/or a phase of said light and/or said detected change of said physical property is a path difference and/or a phase shift of said light.

According to a preferred embodiment said optical cavity/resonator, i.e. said Fabry-Perot cavity/resonator, built by said optical fiber is operating as an interferometer (Fabry-Perot interferometer configuration).

Said operation, i.e. said interferometer, can be realized with said light, i.e. said reference beam and said sensing beam, both travelling through the optical fiber, while said reference beam can be reflected before/not entering said cavity of said optical cavity/resonator ("in-fiber reflection"), i.e. said Fabry-Perot cavity/resonator, whereas said sensing beam can enter said cavity of said optical cavity/resonator, i.e. said Fabry-Perot cavity/resonator, said sensing beam will be reflected therein (optical cavity/resonator) - and said sensing beam will leave said cavity of said optical cavity/resonator, i.e. said Fabry-Perot cavity/resonator, at a "entering side" - while said sensing beam, i.e. said physical property of said sensing beam, will be influenced by said change of said geometrical disposal of said optical cavity/resonator (caused by the magnetostrictive element, i.e. caused by said change in said magnetic field to be detected).

Said (photo-)detector (or said (photo-)detectors) can convert said composite optical beam/said reference and sensing beam into an electrical signal/-s and said control unit can process the electrical signal/-s for detecting a/said optical length and/or a/said path difference and/or a/said phase difference/shift of/between said reference beam and said sensing beam - with said optical length and/or said path difference and/or said phase difference/shift representing said magnetic field, i.e. said change in said magnetic field, to be sensed.

Furthermore, the magnetic sensor arrangement can also be built into a (mounting) assembly for mechanical mounting. The mechanical assembly may also include a pressure-resistant housing for a subsea application.

Multiple units of the magnetic sensor arrangement can be attached to a same system, especially using multiple fiber splitters and lasers of varying wavelengths.

A 3-axis magnetometer can be built by combining three of the magnetic sensor arrangements.

Multiple 3-axis magnetometers can be attached to a same system, especially using multiple fiber splitters and wavelength selective components.

The above-described characteristics, features and advantages of this invention and the manner in which they are achieved are clear and clearly understood in connection with the following description of exemplary embodiments which are explained in connection with the drawings.

### Brief Description of the Drawings

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

The illustrations in the drawings are schematical. It is noted that in different figures, similar or identical elements are provided with the same reference signs.
- FIG 1:: shows schematically a sensing element of an inventive magnetic sensor arrangement with a magnetostrictive layer mechanically linked to an Fabry-Peron cavity/resonator built by an optical fiber,
- FIG 2:: shows schematically the inventive magnetic sensor arrangement with the sensing element arranged in a Helmholtz coil and
- FIG 3:: shows in a schematical wiring diagram the inventive sensor arrangement fit for detecting a magnetic field or a change in a magnetic field with the in-ventive magnetic sensor arrangement operating in a Fabry-Peron interferometer configuration.

### "Fiber Tip Sensor"

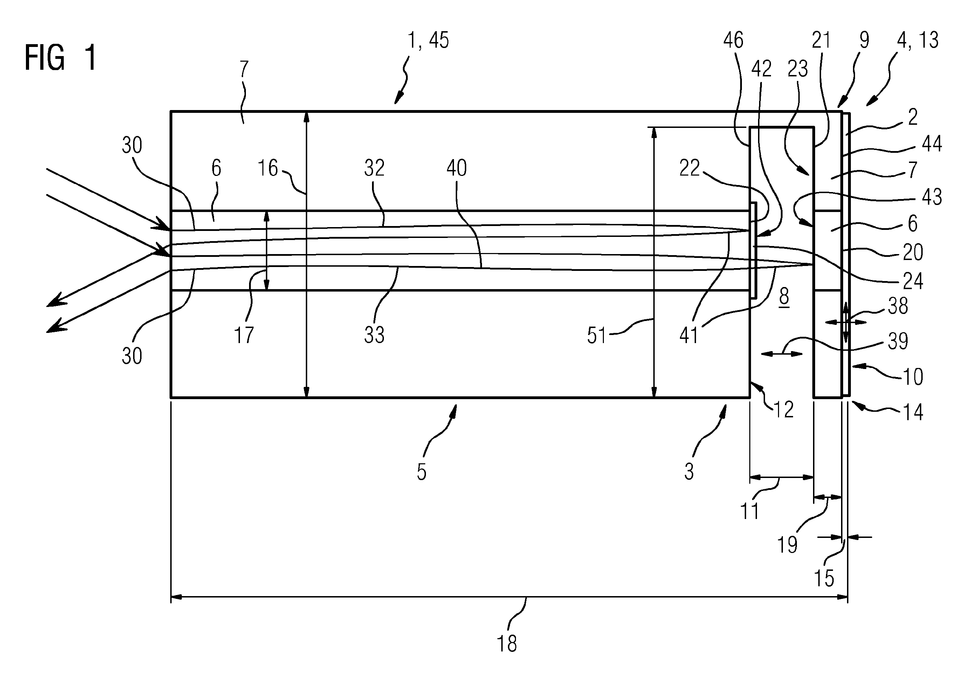

FIG 1 shows a sensing element 45 of a magnetic sensor arrangement 1, in following referred as the "fiber tip sensor", - sensing (external) magnetic fields, i.e. changes in a (external) magnetic field - operating with magnetostriction in combination with an optical cavity/resonator 3, especially a Fabry-Peron cavity/resonator 3.

The fiber tip sensor 1, i.e. the sensing element 45, comprises an optical fiber 5 having a fiber core 6 encased with a fiber cladding 7.

A cross section dimension 16 of the optical fiber 5 is about 120 µm, while a length 18 of the optical fiber 5 is about 80 µm. The fiber core 6 has a cross section dimension 17 of about 6 µm.

A magnetostrictive element 2, built by a magnetostrictive layer 2 - its material being MetGlas and its thickness 15 is about 1 µm - is attached - by sputtering - to a tip 4 of the optical fiber 5 with building a mechanical linkage between the magnetostrictive layer 2 and the optical fiber 5, i.e. the tip 4 of the optical fiber 5.

The Fabry-Perot cavity/resonator 3 of the sensing element 45/fiber tip sensor 1 is being built "in/by" the optical fiber 5 - realized, as shown in FIG 1, as a cantilever arrangement 9 being arranged at a tip region 13 of the optical fiber 5.

The cantilever arrangement 9 - realized "in/by" the optical fiber 5 and building the Fabry-Perot cavity/resonator 3 - comprises a cantilever arm 10; the cantilever arm 10 being an unattached end 14 of the optical fiber 5 with the cantilever arm 10 having a thickness 19 of about 7 µm, and a cantilever base 12.

The cantilever arm 10 is being arranged in a preselectable distance 11 ("length") - of about 7 µm - to the cantilever base 12 with the preselectable distance 11, i.e. respective-opposing - surfaces 21, 46 of the cantilever arm 10 and the cantilever base 12, building/limiting a cavity 8 of the Fabry-Perot cavity/resonator 3.

A width/broadness 51 - normal to of the "length" 11 - of the cavity 8 of the cantilever arrangement 9 is about 110 µm.

The cavity 8/the preselectable distance 11 will be built by laser cutting - cutting fiber material of the fiber 5.

With the magnetostrictive layer 2 - being sputtered on the tip 4 of the optical fiber 5, i.e. on a (outer/end) surface 20 of the cantilever arm 10, and (therefore) being in the mechanical linkage 44 with the cantilever arm 10 of the cantilever arrangement 9 (building the Fabry-Perot cavity/resonator 3/building the cavity 8 of the Fabry-Perot cavity/resonator 3) the cantilever arm 10 will move with a shapes and dimensions change 38 of the magnetostrictive layer 2 - caused by the (external) magnetic field/the change in the (external) magnetic field (110).

While the cantilever arm 10 moving with the (external) magnetic field a geometrical disposal 39 of the cavity 8 of the Fabry-Perot cavity/resonator 3 ("length" of the cavity 8 of the Fabry-Perot cavity/resonator 3) changes respectively (120).

A first inner side 22 of the cavity 8, i.e. the opposing surface 46, is coated - in a region the fiber core 6 will interface the cavity 8 - with a partially reflective material, so that beams 32, 33 (reference beam 32, sensing beam 33) travelling through the fiber 5/fiber core 6 will (on the one hand) be reflected back at the first inner side 22 (reference beam 32) as well as (on the other hand) will enter the cavity 8 (sensing beam 33).

A second inner side 23 - being opposite the first inner side 22 - of the cavity 8 is fully reflective - as the magnetostrictive layer 2 is attached on the tip 4 of the optical fiber 5 - reflecting the beams 33 back (in the cavity 8).

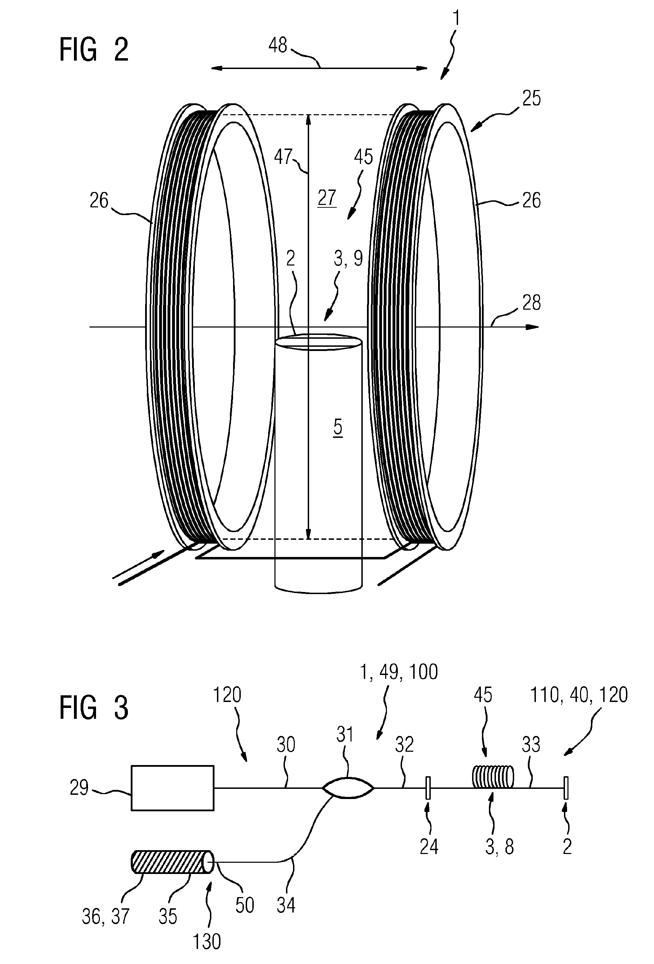

The sensing element 45 of the fiber tip sensor 1 (with its magnetostrictive layer 2 on its end/tip 4) is - as further shown in FIG 2 - arranged in a sensing area 27 of a Helmholtz coil 25 applying a controlled low strength, nearly uniform magnetic field on the sensing element 45/magnetostrictive layer 2 providing a modulation field.

The Helmholtz coil 25 comprises, as shown in FIG 2, a pair of circular magnetic coils 26 - with a cross section dimension 47 of about 10 mm each - that are placed symmetrically - in a distance 48 of about 5 mm to each other - one on each side of - and therefore building - the sensing area 27 along a common axis 28.

Arranging the sensing element 45 (with its magnetostrictive layer 2 on its end/tip 4) in the Helmholtz coil 25, i.e. in the sensing area 27, the optical fiber 5, i.e. the Fabry-Perot cavity/resonator 3, the cantilever arrangement 9 and the magnetostrictive layer 2, is being placed in the sensing area 27.

By using the modulation by the "Helmholtz coil" modulation field the (external) magnetic field to be detected is lifted away (from DC) to a higher frequency where it does not carry interferences from non-magnetic source, like temperature fluctuation, vibration etc..

The fiber tip sensor 1 is built into an assembly (not shown) for mechanical mounting.

Fig 3 shows in a schematical wiring diagram the fiber tip sensor 1 fit for detecting the change in the (external) magnetic field 100 with the fiber tip sensor 1 being arranged/operating in a Fabry-Perot interferometer configuration 49.

Light 30 from a laser source 29, a single wavelength laser light 30, (as it is also shown in FIG 1) passes through a beam splitter/combiner 31, i.e. coupler 31, into the sensing element 45 travelling through the fiber core 6 of the optical fiber 5 (also see FIG 1).

Once being there the laser light/single wavelength laser light 30 will be "splitted" into different beams 32, 33 by different reflection situations ("in-fiber refelction"/"optical cavity/resonator reflection"), i.e. into the reference beam(-s) 32 and the sensing beam(-s) 33 (being coherent from the "same" laser 29).

The reference beam 32 will be reflected (back at the first inner side 22) before/not entering the cavity 8 of the Fabry-Perot cavity/resonator 3 ("in-fiber reflection" by the partial reflection of the coating 24 at the first inner side 22), whereas the sensing beam 33 will enter/illuminating 40 the cavity 8 where the sensing beam 33 will be reflected therein (optical cavity/resonator reflection (reflection at the second inner side 23 by the magnetostrictive layer 2)) (also see FIG 1).

As long as the magnetostrictive layer 2 - being sensible to the change in the (external) magnetic field with sensing the change in the (external) magnetic field on basis of a magnetostrictive effect 2 to its shapes or dimensions change 38 110 - and the Fabry-Peron cavity/resonator 3 are mechanically linked, the change in the (external) magnetic field/the shapes or dimensions change 38 will be sensed by the change in the geometrical disposal 39 of the Fabry-Perot cavity/resonator 3 120.

While changing its geometrical disposal 39, i.e. changing in a geometrical disposal of the opposing mirrors (built by the opposing first and second inner side 22, 23) building the cavity 8, an optical length of the sensing beam 33 will be influenced/changed.

Note, that a (optical) path difference (dL) between the reference beam 32 and the sensing beam 33 is 2*(L_cavity+ L_magnetostrictive) [with L_magnetostrictive is a function of the/all external magnetic fields applied to the magnetostrictive layer 2 ((external) magnetic field to be detected and "helmholtz coil" modulation field)].

As both beams 32, 33 are reflected back - once by the "in-fiber reflection" (at the coating 24) before entering the cavity 8, once again by the reflection at the second inner side 23 inside the cavity (and leaving the cavity 8 at its "entering side" while being partly reflective there) - both beams 32, 33 pass the beam splitter/combiner 31, i.e. coupler 31, being recombined to a composite optical beam 34 with the composite optical beam 34 further arriving at a photodetector 35 at an end of an optical fiber 50 with converting the composite optical beam 34 into an electrical signal 36 (for processing).

The reference beam 32 and the sensing beam 33 now interfere, and a phase difference/shift - being sensible to the path difference dL influenced by the geometrical displacement 39 caused by the (external) magnetic field (magnetostrictive layer 2, cantilever arrangement 9) - is decided by how much the cantilever arrangement 9 is out of shape (change of the geometrical disposal 39).

In other words, the phase shift will be a value representing the (external) magnetic field, i.e. the change in the magnetic field, to be sensed 130.

The phase shift of the reference beam 32 and the sensing beam 33 - as the value representing the change in the (external field to be sensed) - will be processes by a control unit 37 receiving the electrical signal 36 130.

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

Although the invention is illustrated and described in detail by the preferred embodiments, the invention is not limited by the examples disclosed, and other variations can be derived therefrom by a person skilled in the art without departing from the scope of the invention.

## Claims

1. Magnetic sensor arrangement (1) at least comprising a magnetostrictive element (2) and an optical cavity/resonator (3) with said magnetostrictive element (2) being in a mechanical linkage (44) with said optical cavity/resonator (3).

2. Magnetic sensor arrangement (1) according to any preceding arrangement claim wherein
the magnetostrictive element (2) is a magnetostrictive layer (2) or a magnetostrictive ribbon (2) of a material having magnetostricitve properties, especially the magnetostrictive layer (2) or magnetostrictive ribbon (2) having a thickness (15) of about less than 20 µm, further more especially of about 0,1 µm to 10 µm, and/or the material having magnetostricitve properties being an iron-boron alloy or MetGlas.

3. Magnetic sensor arrangement (1) according to any preceding arrangement claim wherein
the magnetostrictive layer (2) or magnetostrictive ribbon (2) is attached to a tip (4) of an optical fiber (5) having a fiber core (6) encased with a fiber cladding (7), especially the optical fiber (5) having a cross section dimension (16) of about 100 µm to 150 µm, furthermore especially of about 110 µm to 130 µm, and/or especially the fiber core (6) having a cross section dimension (17) of about 0,2 µm to 50 µm, furthermore especially of about 4 µm to 8 µm, and/or especially the optical fiber (5) having a length (18) less of about 150 µm, furthermore especially of about 75 µm to 90 µm.

4. Magnetic sensor arrangement according to any preceding arrangement claim wherein
the optical cavity/resonator (3) is build by a Fabry-Perot cavity/resonator (3), especially using an optical fiber (5) comprising a cavity (8) building said optical cavity/resonator (3) and/or said Fabry-Perot cavity/resonator (3), furthermore especially using the optical fiber (5) according to the preceding claim.

5. Magnetic sensor arrangement (1) according to any preceding arrangement claim wherein
the optical cavity/resonator (3), especially the Fabry-Perot cavity/resonator (3), is being built by a cantilever arrangement (9) with a cantilever arm (10) being arranged in a preselectable distance (11) to a cantilever base (12), especially said cantilever arm (10) and said cantilever base (12) being arranged in said preselectable distance (11) building a cavity (8) of said optical cavity/resonator (3), especially said Fabry-Perot cavity/resonator (3).

6. Magnetic sensor arrangement (1) according at least to the preceding arrangement claim wherein
said preselectable distance (11) ("length") being about 5 to 25 µm and/or said cantilever arm (10) having a thickness (19) of about 5 to 25 µm.

7. Magnetic sensor arrangement (1) according at least to one of the two preceding arrangement claim wherein
the cantilever arrangement (9) is built using an optical fiber (5), especially the optical fiber (5) according to claim 4, furthermore especially the cantilever arrangement (9) being arranged at a tip region (13) of an optical fiber (5), especially of the optical fiber (5) according to claim 4, with the cantilever arm (10) being an unattached end (14) of the optical fiber (5), especially of the optical fiber (5) according to claim 4.

8. Magnetic sensor arrangement (1) according to any preceding arrangement claim wherein
the mechanical linkage (44) of said magnetostrictive element (2) with said optical cavity/resonator (3) is built by using a sputtering or gluing technique.

9. Magnetic sensor arrangement (1) according to any preceding arrangement claim wherein
said magnetostrictive element (2) is attached to a surface (20) of said cantilever arm (10) of the cantilever arrangement (9) according to claim 5, especially said surface (20) of the cantilever arm (10) being opposite to a further surface (21) of the cantilever arm (10) with said further surface (21) limiting the cavity (8) of said optical cavity/resonator (3), furthermore especially said cantilever arrangement (9) being according to claim 7.

10. Magnetic sensor arrangement (1) according to any preceding arrangement claim wherein
a first inner side (22) of a cavity (8) of said optical cavity/resonator (3) is partially reflective, especially using a coating (24) of a partially reflective material, whereas a second inner side (23) of said cavity (8) is fully reflective, especially using said magnetostrictive element (2).

11. Magnetic sensor arrangement (1) according to any preceding arrangement claim further comprising
a coil arrangement (25), especially comprising a Helmholtz coil (25), comprising circular magnetic coils (26) that are placed symmetrically one on each side of a sensing area (27) along a common axis (28) with said optical cavity/resonator (3) being placed in said sensing area (27).

12. Magnetic sensor arrangement (1) according to any preceding arrangement claim further comprising
a laser source (29) for producing an optical laser light (30), especially of a single wavelength, and/or an optical coupler (31) for dividing the optical laser light (30) into a first and second optical beam (32, 33) and/or for combining the first and second optical beam (32, 33) into a composite optical beam (34) and/or a detector (35) for converting said composite optical beam (34) into an electrical signal (36) and/or a control unit (37) for processing the electrical signal (36).

13. Method (100) for detecting a change in a magnetic field comprising the steps of
- sensing a change in a magnetic field on basis of a magnetostrictive effect (2) with transducing the change in the magnetic field in a shapes or dimensions change (38) by said magnetostrictive effect (2), (110),
- transferring the shapes or dimensions change (38) in a change of a geometrical disposal (39) of an optical cavity/resonator (3) while illuminating (40) the optical cavity/resonator (3) by light (120) and
- detecting a change of a physical property of the light (30), (41) illuminating (40) the optical cavity/resonator (3), (130) caused by the change of the geometrical disposal (39) of the optical cavity/resonator (3) with the change of the physical property (41) of the light (30) representing the change in the magnetic field.

14. Method according to any preceding method claim wherein the physical property of the light (30) is phase of the light (30) and/or the detected change of said physical property (41) is a phase shift of the light (30).

15. Method according to any preceding method claim wherein the change of the geometrical disposal (39) of the optical cavity/resonator (3) is a change in a geometrical disposal (39) of mirrors (42, 43) building a cavity (8) of said optical cavity/resonator (3).
